# EUROPEAN PATENT APPLICATION

(11) **EP 1 363 436 A2**
(43) Date of publication of application: **19.11.2003**
(21) Application number: 03252984.4
(22) Date of filing: 14.05.2003
(51) Int. Cl.: H04L 27/26

(54) **Synchronization of multicarrier symbols**

(30) Priority: 17.05.2002 GB 0211400
(71) Applicant: BRITISH BROADCASTING CORPORATION, London W1A 1AA (GB)
(72) Inventor: Clarke, Christopher K. P., British Broad. Corp., Tadworth, Surrey KT20 6NP (GB)
(74) Representative: Abnett, Richard Charles

(57) **Abstract**

A timing synchronization circuit for an OFDM signal receiver includes a symbol pulse separator (14-20) coupled to an input (12) for separating a symbol pulse from the received OFDM signal, phase comparison circuitry (72), a proportional and an integral loop filter (52; 54,56) the outputs of which are combined to control a clock (40), and a symbol divider (42) coupled to the output of the clock for providing symbol rate pulses for timing and synchronization control, and also for generating the comparison waveforms which are applied to the phase comparison circuitry. In such a timing synchronization circuit the symbol divider circuit (42) generates different first and second comparison waveforms, and the phase comparison circuitry (72) comprises first and second phase comparators (86,88) for comparing the separated symbol pulses with the different first and second comparison waveforms respectively. The first phase comparator provides an output to the first loop filter circuit and the second phase comparator provides an output to the second loop filter circuit. The time synchronization system can consistently choose an optimum position to start the FFT in the OFDM receiver over a wide range of signal conditions.

## Description

### Background of the Invention

This invention relates to the time synchronization of signals in a receiver for Orthogonal Frequency Division Multiplex (OFDM) signals. OFDM signals comprise a plurality of symbol periods during each of which a plurality of bits are carried on a corresponding plurality of carriers. Each full symbol period comprises an active symbol period and a guard band. The signals are recovered into a single bitstream with the use of a Fast Fourier Transform circuit, which must be synchronized to the incoming OFDM signal.

More particularly, time synchronization in an OFDM receiver involves both (a) locking the clock frequency to the carrier structure and (b) deriving a pulse at an appropriate position in the symbol period to start the Fast Fourier Transform (FFT). It is important that in relation to (b) the demodulator consistently chooses the optimum start position, so that unnecessary decoding failures can be avoided, but the selection of an optimum position to start the FFT under a wide range of echo conditions has proved difficult.

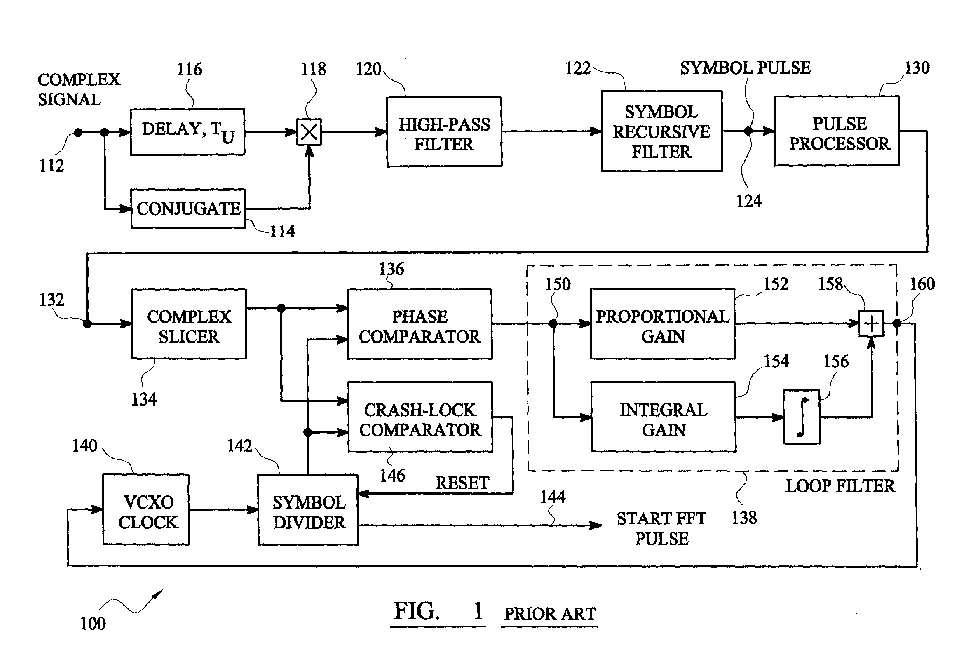

The method described in our United Kingdom patent specification GB 2 361 157A uses the technique of correlating the received OFDM signal with a delayed version of itself, as shown in Figure 1. The input signal to the synchronization circuit 100 is in the form of a digital signal consisting of complex samples (co-timed real and imaginary values) such as might be obtained by down-conversion of the received radio frequency signals, followed by analogue-to-digital conversion and then conversion from real to complex form. The input signal received at 112 is applied to a conjugation circuit 114 which generates the complex conjugate of the input signal. A complex multiplier 118 has one input connected to the output of the conjugation circuit and its other input is coupled to the input 112 through a correlation delay 116 with delay time T_{U}. The output of the multiplier 118 is applied to a high-pass filter 120, the output of which is in turn coupled to a symbol recursive filter 122. The output 124 of this then provides a symbol pulse. For further details reference should be made to GB 2 361 157A. That specification also describes the subsequent step of removing any phase rotation of the complex pulse values and forming a positive-going real pulse value, this operation being indicated by the pulse processor 130 in Figure 1. It may simply be achieved by adding the magnitude of the real and imaginary components.

The correlation delay 116 is equal to the active or useful symbol period T_{U} of the OFDM signal, that is, the period not including the guard interval, and can be implemented as a delay of a whole number of clock periods, provided that the clock is always reasonably close to its correct frequency. The correlation is made using the complex multiplier 118, one input of which accepts the conjugated version of the signal from the conjugation circuit 114, that is, the signal with the imaginary component inverted. The conjugation can be used at either the delayed or the undelayed input to the multiplier; it is shown in the undelayed input. This process reveals the position of the guard interval in the received signal, in the form of a complex pulse. It therefore forms a basis both for function (b), namely selecting the FFT start, by its position in time, and for function (a), namely sampling clock synchronization, through the relationship between the clock and symbol frequencies.

However, the pulse produced by the correlation operation can be affected by noise which results from the contribution of the changing data values in the modulated signal. Also, if sinusoidal interference is present, the principal effect is the addition of a complex offset to the pulse signal. Because of this, the multiplier 118 is followed by two filters, the high-pass filter 120 to remove any dc offset, and the symbol recursive filter 122 to remove noise. The symbol recursive filter combines contributions one full symbol period apart, that is, the symbol period including the guard interval. Although the high-pass filter 120 is shown to precede the symbol filter 122 in Figure 1, they could be in the other order with the high-pass filter following the symbol filter.

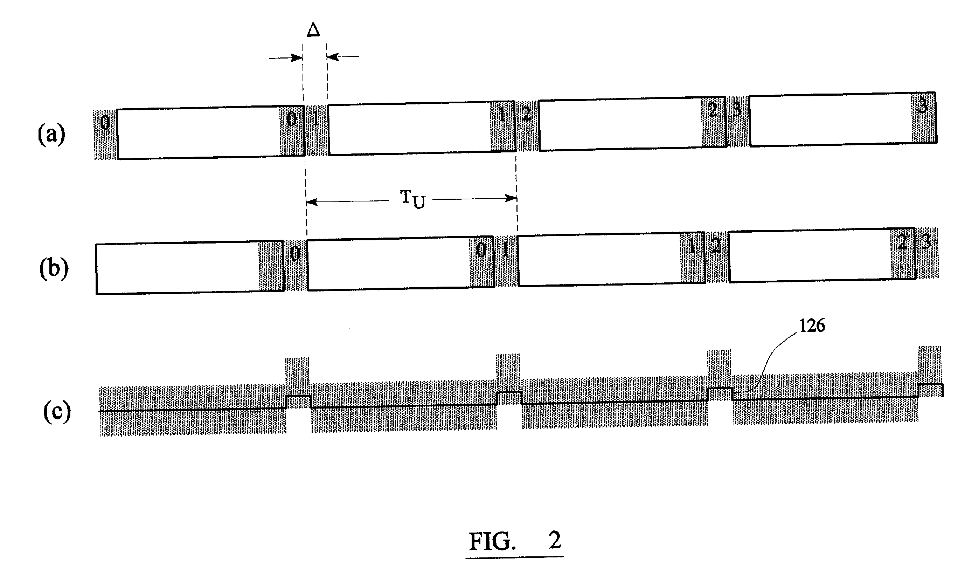

Figure 2 will now be used to explain the basis of obtaining the symbol pulse. The received OFDM waveform is noise-like and therefore difficult to represent in a diagram. In Figure 2 at (a), the signal is shown as a series of symbols, four being shown numbered 0 to 3. Each symbol comprises an active symbol period T_{U}, preceded by a guard interval of duration Δ, and which together make the full symbol period T_{S} = T_{U} + Δ. The guard interval waveform is the final portion of the active symbol period waveform repeated and placed in front of the active symbol. Similarly, (b) in Figure 2 shows the same signal delayed by the active symbol period T_{U}, so that the repeated sections of the two waveforms are coincident. The correlated signal is also noise-like (shown shaded at (c) in Figure 2), but has a different distribution of values during the guard interval period from that during the remaining symbol period. After the filtering processes of Figure 1, the basic form of the symbol pulse is revealed as the solid line 126 at (c) in Figure 2, that is with one pulse per symbol period which is equal in duration to the guard interval and which occurs at the end of the active symbol period in the input.

The orientation of the pulse in the complex waveform is affected by any local oscillator frequency error in the receiver, which results in the complex pulse being rotated from its in-lock position on the positive real axis. Thus, in GB 2 361 157A, a complex slicer is used to take account of phase rotation and to produce a symbol pulse for comparison with a pulse divided from the clock frequency, as shown in Figure 1. The circuit of Figure 1 thus includes a complex slicer 134 which receives the separated symbol pulse at an input 132. The output of the complex slicer is applied to one input of a phase comparator 136. In the phase comparator, a pulse generated from the leading edge of the sliced symbol pulse waveform is used to sample a ramp waveform generated from the symbol divider circuit 142 (see Fig. 7 of GB 2 361 157A). The comparator output is applied through a loop filter 138, described below, to a voltage controlled crystal oscillator (VCXO) 140 operating as the clock source. The clock output is applied to a symbol divider 142 which divides the clock frequency down to the symbol rate and provides at 144 a pulse to time the start of the FFT in the OFDM demodulator. An output of the symbol divider 142 is also fed back as the second or comparison input to the phase comparator 136.

The phase comparator 136 produces an error signal which is filtered in filter 138 to give the loop the desired dynamic characteristics, and is applied to control the frequency of the voltage-controlled crystal oscillator 140.

It is necessary, on the one hand, to limit the clock frequency variations (for correct operation of the correlator 114-118 and to suppress sampling noise) and, on the other hand, to overcome a large initial symbol phase offset. Altering the clock frequency to drive the local symbol phase into synchronism would simply take too long, so a crash-lock comparator 146 is used to reset the divider 142 if the symbol phase is found to be significantly incorrect. To that end the crash-lock comparator 146 receives the same inputs as does the phase comparator 136.

The loop filter 138 consists of a proportional term and an integral term, each of which is weighted by an appropriate gain factor before being added together to form the oscillator frequency control signal. That is, the loop filter 138 has an input 150 which is connected to the output of the phase comparator 136 to receive the error signal from the comparator. A proportional gain circuit 152 and an integral gain circuit are each connected to the input 150. These are well-known types of circuit commonly used in control loop technology and are thus not described in detail. They take the form of an amplifier or attenuator, to provide appropriate weighting to the signal applied to them respectively. The output of the integral gain attenuator 154 is integrated in an integrator 156, and the output of the integrator 156 and the output of the proportional gain attenuator 152 are combined in an adder 158. The output 160 of the adder provides the control signal from the loop filter 138 which is used to control the clock oscillator 140.

The use of an integral term provided by the integrator 156 is particularly beneficial because it ensures that the loop can lock in the correct phase to the incoming signal, even though the rest frequency of the oscillator may not be precisely correct.

When the received signal is affected by multipath propagation, that is echoes, the shape of the pulse is modified from its simple rectangular form. The slicer system used in GB 2 361 157A as described above deals with this by attempting to find the beginning of the pulse from the correlator, specifically by slicing at one quarter of the way up the rising edge of the pulse. This works satisfactorily for virtually all circumstances with static reception of a single transmitter. However, we have found that in circumstances where there are multiple transmitters, such as in a Single Frequency Network (SFN), or in mobile situations where either the transmitter or the receiver is moving and blocking of the main path can occur, difficulties can arise.

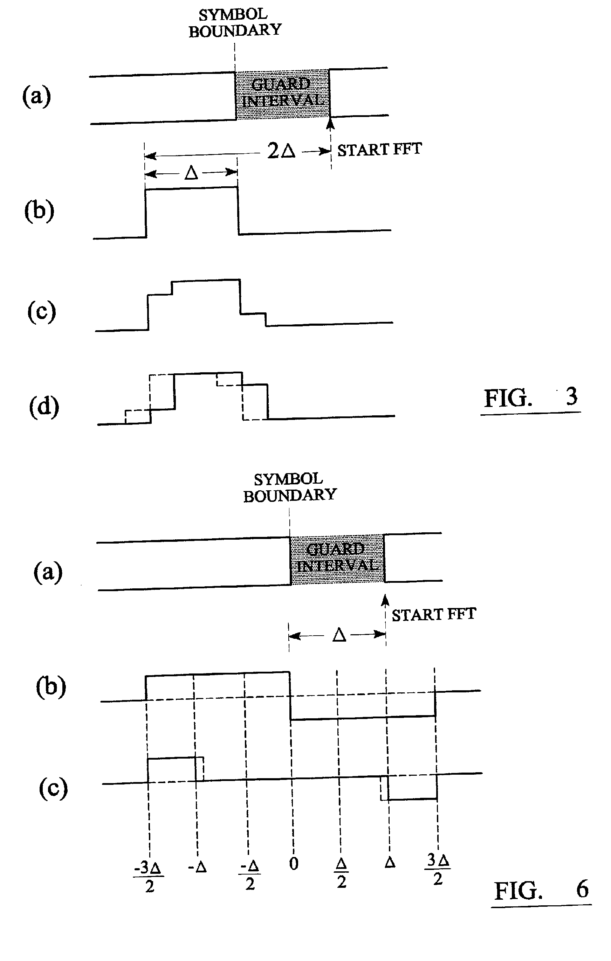

The waveform diagrams of (a) and (b) in Figure 3 show the relationship in time of the guard interval portion of the received signal shown at (a), the symbol pulse produced by correlation shown at (b), and the optimum position to start the FFT, which is at time 2Δ after the rising edge of the symbol pulse. Any delayed versions of the signal such as produced by echoes affect the received signal by overlaying components from the previous symbol progressively into the guard interval region. Thus no inter-symbol interference occurs until the path delay exceeds Δ, which is the theoretical capacity of the system to withstand echoes. Accordingly, the separated symbol pulse waveform might take the form shown at (c) in Figure 3, in which the amplitude of the delayed path is somewhat less than that of the first path. As the earliest component is large and is readily detected by the slicer, this proves satisfactory. However, if the earliest component is smaller in amplitude than a subsequent path, such as shown in the unbroken line at (d) in Figure 3, it may be missed by the slicer, as shown dashed, so that the optimum point to start the FFT will not be correctly located. Simply reducing the slicing level to significantly below one quarter is not a practical option because of the possibility of false triggering due to residual noise and distortion on the baseline of the pulse.

More generally, proposals have been made which satisfactorily lock the clock frequency, but which fail to point a consistent indication of the optimum position to start the FFT, in the presence of various different types of multipath interference over a wide range of relative amplitudes of the main and interfering signals. Examples of other proposals with regard to symbol timing of OFDM signals are to be found in United Kingdom Patent Application 2 307 155A, European Patent Application 1 126 673A, and United States Patent 5,559,833.

### SUMMARY OF THE INVENTION

The invention in its various aspects is defined in the independent claims below to which reference should first be made. Advantageous features are set forth in the appendant claims.

A preferred timing synchronization circuit embodying the invention is described in more detail below with reference to the drawings. The timing synchronization circuit is designed for use in an OFDM signal receiver which has a Fast Fourier Transform circuit. The timing synchronization circuit includes a symbol pulse separator coupled to an input for separating a symbol pulse from the received OFDM signal, phase comparison circuitry, a proportional and an integral loop filter the outputs of which are combined to control a clock, and a symbol divider coupled to the output of the clock for providing symbol rate pulses for timing and synchronization control, and also for generating the comparison waveforms which are applied to the phase comparison circuitry.

In such a timing synchronization circuit the symbol divider circuit generates different first and second comparison waveforms, and the phase comparison circuitry comprises first and second phase comparators for comparing the separated symbol pulses with the different first and second comparison waveforms respectively. The first phase comparator provides an output to the first loop filter circuit and the second phase comparator provides an output to the second loop filter circuit.

The time synchronization system can consistently choose the proper position to start the FFT in the OFDM receiver over a wide range of signal conditions.

### BRIEF DESCRIPTION OF THE DRAWINGS

The invention will now be described in more detail, by way of example, with reference to the accompanying drawings, in which:
**Figure 1** (referred to above) is a block schematic diagram of a known time synchronization circuit for use in an OFDM receiver;
**Figure 2** (referred to above) is a diagram illustrating the structure of an OFDM signal and the operation of the circuit of Figure 1;
**Figure 3** (referred to above) is a timing diagram illustrating problems which we have found can arise with the circuit of Figure 1;
**Figure 4** is a block schematic diagram of a preferred time synchronization circuit embodying the invention for use in an OFDM receiver;
**Figure 5** illustrates waveforms which arise in the circuit of Figure 4; and
**Figure 6** is a diagram similar to Figure 3 showing possible modifications to the waveforms in the circuit of Figure 4.

### DETAILED DESCRIPTION OF THE PREFERRED EMBODIMENT

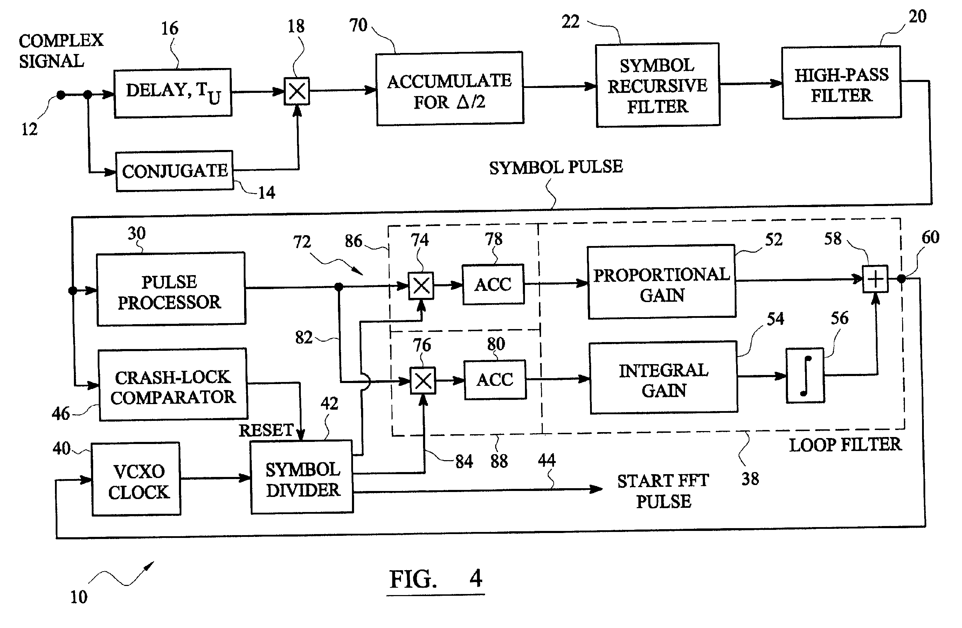

A preferred embodiment of the invention will now be described with reference to Figure 4. Elements which correspond to the elements of the known system described with reference to Figure 1 have reference numerals which differ therefrom by 100.

The time synchronization circuit shown in Figure 4 is designed for use in an OFDM receiver, more particularly in a DVB-T (Digital Video Broadcasting-Terrestrial) receiver. The structure of a DVB-T receiver is described in our European Patent Application 02250062.3, Publication No. 1,221,793 to which reference should be made for a fuller description of the context in which the time synchronization circuit may be used. A knowledge of the content of both GB 2 361 157A and European Patent Application Publication 1,221,793 is assumed in the following description, and these documents are hereby incorporated herein.

The input signal to the OFDM time synchronization circuit 10 is, as with Figure 1, in the form of a digital signal consisting of complex samples (co-timed real and imaginary values) such as might be obtained by down-conversion of the received radio frequency signals, followed by analogue-to-digital conversion and then conversion from real to complex form. The input signal received at 12 is applied to a conjugation circuit 14 which generates the complex conjugate of the input signal. A complex multiplier 18 has one input connected to the output of the conjugation circuit and its other input is coupled to the input 12 through a correlation delay 16 with delay time T_{U}. The output of the complex multiplier 18 is applied to an accumulator 70 which accumulates for time periods of half the guard interval, Δ/2; this is described more fully below. The output of the accumulator 70 is applied to a symbol recursive filter 22, the output of which is in turn coupled to a high-pass filter 20. The output 124 of this then provides a symbol pulse. For further details of the symbol pulse separator constituted by the elements 14 - 20 reference should again be made to GB 2 361 157A. The output of filter 20 is applied to a pulse processor 30 the functions of which again include removing any phase rotation of the complex pulse values and forming a positive-going real pulse value. This function may simply be achieved by adding the magnitude of the real and imaginary components.

The correlation delay 16 is equal to the active or useful symbol period T_{U} of the OFDM signal, that is, the part not including the guard interval, and can be implemented as a delay of a whole number of clock periods, provided that the clock is always reasonably close to its correct frequency. The correlation is made using the complex multiplier 18, one input of which accepts the conjugated version of the signal from the conjugation circuit 14, that is, the signal with the imaginary component inverted. The conjugation can be used at either the delayed or the undelayed input to the multiplier; it is shown in the undelayed input. This process reveals the position of the guard interval in the received signal, in the form of a complex pulse. It therefore forms a basis both for function (b), namely selecting the FFT start, by its position in time, and for function (a), namely sampling clock synchronization, through the relationship between the clock and symbol frequencies.

As described above in relation to the known circuit of Figure 1, the separated symbol pulse produced by the correlation operation (14-18) can be affected by noise which results from the contribution of the changing data values in the modulated signal. Also, if sinusoidal interference is present, the principal effect is the addition of a complex offset to the pulse signal. Because of this, the multiplier 18 is followed by two filters, the high-pass filter 20 to remove any dc offset, and the symbol recursive filter 22 to remove noise. The symbol recursive filter combines contributions one full symbol period apart, that is, the symbol period including the guard interval. Although the high-pass filter 20 is shown to follow the symbol filter 22 in Figure 4, they could be in the other order with the high-pass filter preceding the symbol filter.

Ignoring for the moment the effect of the accumulator 70, this part of the time synchronization circuit operates the same way as in Figure 1. That is, in Figure 2 at (a), the signal is shown as a series of symbols, four being shown numbered 0 to 3. Each symbol comprises an active symbol period T_{U}, preceded by a guard interval of duration Δ, and which together make the full symbol period T_{S} = T_{U} + Δ. The guard interval waveform is the final portion of the active symbol period waveform repeated and placed in front of the active symbol. Again, (b) in Figure 2 shows the same signal delayed by the active symbol period T_{U} so that the repeated sections of the two waveforms are coincident. The correlated signal is also noise-like (shown shaded at (c) in Figure 2), but has a different distribution of values during the guard interval period from that during the remaining symbol period. After the filtering processes of Figure 4, the basic form of the symbol pulse again takes the form of the solid line 126 at (c) in Figure 2, that is with one pulse per symbol period which is equal in duration to the guard interval and which occurs at the end of the active symbol period in the input.

The orientation of the pulse in the complex waveform is affected by any local oscillator frequency error in the receiver, which results in the complex pulse being rotated from its in-lock position on the positive real axis. In Figure 1, a complex slicer was used to take account of phase rotation and to produce a symbol pulse for comparison with a pulse divided from the clock frequency. The complex slicer is omitted in the circuit of Figure 4, though some modification is preferably made to the pulse processor 30, as described below. The output of the pulse processor is applied to a phase comparator circuit 72 which comprises two phase comparators, namely a first phase comparator 86 and a second phase comparator 88. The output of the pulse processor 30 is thus applied to one input of each of the two phase comparators. The phase comparators each comprise a multiplier 74,76 followed by an accumulator 78,80 which accumulates over a symbol period. The comparator outputs are each applied to respective inputs of a loop filter 38, described below, the output of which is applied to a voltage controlled crystal oscillator (VCXO) 40 operating as the clock source. The clock output is applied to a symbol divider 42 which divides the clock frequency down to the symbol rate and provides at 44 a pulse to time the start of the FFT in the OFDM demodulator. An output of the symbol divider 42 is also fed back as the second or comparison input to each of the two phase comparators 86,88.

The phase comparators 86,88 produce error signals which are combined and filtered in filter 38 to give the loop the desired dynamic characteristics. The filtered error signal is applied to control the frequency of the voltage-controlled crystal oscillator 40.

It is again necessary, on the one hand, to limit the clock frequency variations (for correct operation of the correlator and to suppress sampling noise) and, on the other hand, to overcome a large initial symbol phase offset. Altering the clock frequency to drive the local symbol phase into synchronism would as with Figure 1 simply take too long, so a crash-lock comparator 46 is used to reset the divider 42 if the symbol phase is found to be significantly incorrect. To that end the crash-lock comparator 46, which differs from that of Figure 1 and is further described below, receives the output of the high-pass filter 20.

The loop filter 38 again consists of a proportional term and an integral term, each of which is weighted by an appropriate gain factor before being added together to form the oscillator frequency control signal. In this case, however, a proportional gain attenuator 52 and an integral gain attenuator are respectively connected to the outputs of the first and second phase comparators 86,88. These attenuators are well-known types of circuit commonly used in control loop technology and are thus not described in detail. They take the form of an amplifier or attenuator, to provide appropriate weighting to the signal applied to them respectively. The output of the integral gain attenuator 54 is integrated in an integrator 56, and the output of the integrator 56 and the output of the proportional gain attenuator 52 are combined in an adder 58. The output 60 of the adder provides the control signal from the filter 38 which is used to control the clock oscillator 40.

The operation of the circuit of Figure 4 will now be described.

We have appreciated that in reality the circuit needs to control two separate quantities by means of one control signal. On the one hand, the *clock frequency* needs to be controlled in relation to the frequency of the received symbol pulse, while on the other hand, the local *symbol phase,* as represented by the symbol divider 42, needs to be locked to the received symbol pulse phase. Thus in the system illustrated in Figure 4, two separate controls are employed, one sensing the symbol frequency and the other the symbol phase. These are applied, as far as possible independently, to control one quantity, namely the clock frequency.

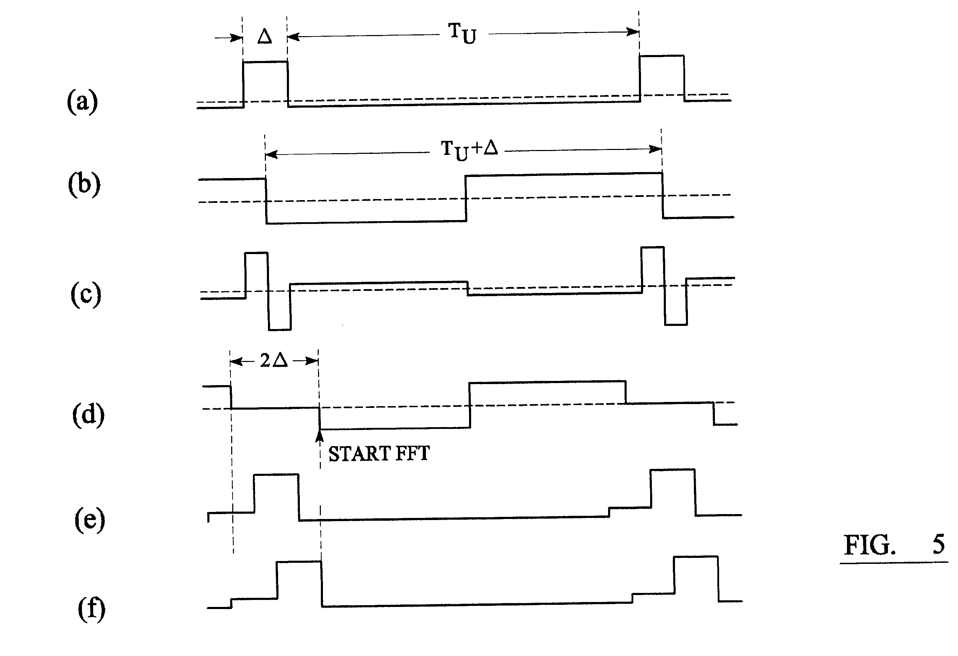

Referring to Figure 5, the separated symbol pulse is shown at (a). The first phase comparator 86 receives from the symbol divider a comparison waveform in the form of a square symbol rate waveform as shown at (b), derived from the symbol divider 42. The resultant of multiplying the waveforms at (a) and (b) in Figure 5 is to produce a product waveform as shown at (c). The waveform at (a) extends above and below the zero line (shown dashed) because the dc component is removed by the high-pass filter 20. The multiplier 74 in the phase comparator 86 produces the product of the square waveform and the separated symbol pulse, and the accumulator 78 averages the product waveform (c) over a full symbol period to form the error signal. The error signal becomes zero when the phase relationship between (a) and (b) is as shown, because this equalises the positive and negative areas of waveform (c). The loop will therefore lock in this phase.

The second comparator 88 receives a comparison waveform shown at (d) in Figure 5, which is a modification of waveform (b) with a dead band forming a defined range 2Δ wide covering the desired symbol pulse position. The first phase comparator 86 works as an equal area detector to control primarily the symbol frequency, as just described, while, for the most part, the second phase comparator 88 produces no significant output. However, with a separated pulse waveform such as that of (e), the natural lock position for the first phase comparator on its own might be as shown at (e), so that part of the pulse falls outside the dead band, rather than in the desired position as shown by the main pulse at (f). As seen in (e), the received symbol pulse includes an 'echo' ahead of the main pulse. This initial smaller pulse may be less than 25% of the height of the main pulse. It is part of this smaller pulse which falls outside the dead band, namely ahead of it or to the left as seen in Figure 5. Because of this, the second phase comparator 88 will produce an output indicating that the first phase comparator has failed to produce a suitable lock point, and the FFT start will be wrongly positioned.

Thus, the first phase comparator responds over the full range of relative phase positions of the input symbol pulses, whereas the second phase comparator, due to the dead band, only responds outside a defined range of relative input phase positions centred on the desired phase position.

In accordance with the system illustrated in Figure 4, the two error signals are applied through different paths in the loop filter 38. Simply combining the error signals by adding the outputs from the two comparators would not yield the desired result, because the two controls would each dilute the effect of the other.

Thus the error signal from the first phase comparator 86 is used to apply a simple proportional control through the proportional circuit 52 to the clock oscillator 40. The second detector 88, sensing an imbalance caused by any parts of the pulse falling outside the correctable window two guard intervals (2Δ) wide as defined by waveform (d), is also applied to control the clock frequency, but in this case through the integrator 56, applying integral control. The integrator contribution will not change the clock frequency (in the long term), but will build up a value to offset the error in position resulting from the equal area control provided by the proportional circuit 52. This will force the pulse to be accommodated in the required window, as shown at (f) in Figure 5, provided that its total extent does not exceed the 2Δ limit. Positioning the FFT start at the end of the 2Δ window then ensures that the full capacity of the system to compensate for echoes up to the theoretical delay limit of Δ is obtained.

Thus, in this system, the proportional and integral loop filter components are fed from two separate phase detectors 86,88, effectively resulting in two loops controlling the clock frequency, to effectively adjust the symbol frequency and phase substantially separately even though only one control signal results.

In common with other clock and time synchronisation methods in OFDM systems, care is needed to avoid interdependence between the clock loop and the other control systems of the receiver, such as the automatic frequency control and gain control loops.

Variations in the height or magnitude of the separated symbol pulse, which can occur as a result of echoes or by interfering signals affecting the receiver automatic gain control, are undesirable. This is because the variations have the effect of altering the proportional and integral gain factors which determine the stability characteristics of the control loop. It is an advantage, therefore, to normalise the pulse height to a reference level before generating the control signals, and this can be achieved in the pulse processor 30.

If the separated symbol pulse used to derive the two control signals were processed in a similar manner to that used with the previous slicing technique of Figure 1, employing the complex slicer 134, then noise components in the correlated pulse would be suppressed with a symbol recursive low-pass filter. While the same arrangement can still be used with the two-comparator system of Figure 4, a slight rearrangement of the circuit can produce a worthwhile reduction in the amount of storage required. This will now be described.

The accumulator circuits 78,80 average large groups of samples together. Because of the piecewise-constant form of the control waveforms in Figure 5, it is possible to move most of the accumulation process in front of the symbol recursive filter 22. This is the function achieved by the accumulator 70 in Figure 4. Thus, for the most part, groups of samples up to Δ/2 in duration can be reduced to a single complex sample. Although the symbol-to-symbol averaging provided by the symbol recursive filter is still needed, this sub-sampling dramatically reduces the amount of storage required in this filter.

In summary, therefore, the operation of the system of Figure 4 is as follows. First the complex signal is correlated in multiplier 18 across the active symbol delay 16, as described for the known arrangement of Figure 1. Then the complex samples are accumulated in accumulator 70 for a period equal to half the guard interval (obtained from the symbol divider 42) to produce a smaller number of Δ/2 samples. For guard intervals of 1/4, 1/8, 1/16 or 1/32 this produces respectively 10, 18, 34 or 66 samples of length Δ/2 per symbol period, instead of several thousand. These values are filtered, first by the symbol recursive filter 22 and then by the high-pass filter 20. It is preferable to use a high-pass filter arranged as a low-pass filter and a subtractor, and to hold the subtracted dc value for a symbol period. This prevents any variations of the dc value during the symbol period affecting the control waveforms. The pulse processor 30 then removes any phase rotation of the complex pulse values, forming a positive-going real pulse value, normalised in height to a reference value in processor 30, so that the output pulse has a constant amplitude.

The multiply-accumulate or phase comparison process is then greatly simplified, by virtue of the accumulator 70. The function required can be derived from inspection of waveforms (b) and (d) on Figure 5. For example, with a guard band of 1/8, where there are 18 samples per symbol or 9 samples per half-symbol, the first phase comparison consists of adding nine values and subtracting nine values under the control of the symbol divider 42 to provide the proportional control term. With other guard bands the numbers are different. More generally, a consecutive half of the samples are added and the other half subtracted. The second phase comparison involves ignoring four samples, subtracting seven samples, and adding seven samples to provide the integral term. More generally, four samples are ignored, and then a consecutive half of the remainder are added and the other half subtracted. After applying suitable proportional and integral gains, the proportional and integrator outputs are added in adder 58 to produce the frequency control for the clock oscillator 40.

The symbol divider 42 counts clock periods to produce the required symbol rate waveforms for controlling the various circuits, and provides the appropriately phased pulse at 44 to start the Fast Fourier Transform. The crash-lock comparator 46 identifies the position of the largest amplitude of the accumulated complex samples, and if this falls outside the four central Δ/2 periods, resets the divider to the +Δ/2 position.

A modification will now be described with reference to Figure 6. It will be appreciated that all of the significant information in the separated symbol waveform is contained in the region of the pulse itself, while for the remainder of the symbol period the waveform contributes only noise. When the system is in lock or close to the locking point, this part of the waveform falls within, or close to, the 2Δ dead band of Figure 5 at (d). Because of this, it is an advantage to modify the control waveforms of both (b) and (d) by setting all the contributions outside a ±3Δ/2 window to zero, as shown in Figure 6 at (b) and (c). This 3Δ width of window retains all the relevant parts of the pulse waveform, forming a second wider defined range wider than the 2Δ range shown in Figure 5, and rejects the remaining noise contributions. It is then necessary to provide that the symbol pulse falls within the active region of these truncated control signals, see below.

With the system so far described, there is the disadvantage that the pulse has to extend beyond the edge of the 2Δ range before the second control signal is generated to correct the problem. This will cause inter-symbol interference which will degrade the system performance and could produce errors in the demodulated data. This can be avoided by slightly extending the active range of the second comparator control waveform to the form shown dashed at (c) in Figure 6. That is to say the first defined range is now in fact slightly less than 2Δ. Accordingly the integral control starts a few samples before the positional error generates inter-symbol interference. This reduces the range of path delay that the system can accommodate to below the theoretical guard band limit of Δ, but not significantly. An additional effect of this modification is that, in the practical circumstances where noise and distortion affect the signals, it removes points of marginal stability at the limits of the 2Δ range. It should be noted that, with the sub-sampling technique using the accumulator 70, special provision needs to be made to store and filter the small extensions of the waveform of (c) in Figure 6, which could be processed as two extra samples.

The multiply-accumulate or phase comparison process is now further simplified if the Figure 6 modification is used, when using the accumulator 70. It consists simply of adding three values and subtracting three values under the control of the symbol divider 42 in the case of the proportional control term, or adding one value and subtracting another for the integral term.

It should be appreciated that the basic loop could be extended from the form shown in Figure 4. In particular, adding a proportional contribution from the second phase detector 88, using the control waveform shown at (c) in Figure 6, would improve stability over that of the integrator alone. It may be noticed that this is equivalent to using a first phase detector waveform with an increased gain contribution in the regions from -3Δ/2 to -Δ and from Δ to 3Δ/2.

In a conventional loop, the integrator term is included to prevent a frequency error (for example, in the nominal frequency of the clock oscillator) resulting in a phase error when locked. With the arrangement of Figure 4, the proportional control will result in the position of the pulse changing as a result of frequency errors. This is not a problem, however, unless it causes part of the pulse to extend outside the -Δ to Δ range in Figure 6. In that case, the second phase comparator 88 will operate to correct the position in the normal way and the integrator will produce a value to compensate for the frequency error.

As noted above, because the comparator waveforms of Figure 6 are active over only part of the symbol period, there is the possibility that the separated symbol pulse will not fall into the 3Δ active range. Under these circumstances, the crash-lock circuit 46 is used to reset the symbol divider so that the pulse does fall in the active range. Even if the full waveforms of Figure 5 are used, such a mechanism is still required, as shown in Figure 4, because the time take to move the symbol through a large phase by changing the clock frequency is too great. The crash-lock circuit however operates differently from the corresponding circuit in Figure 1.

The basis of a reliable crash-lock technique lies in measuring the position of the main energy in the output of the correlator, i.e. the multiplier 18. When near to the lock point, the main part of the pulse will fall in the region between -Δ and +Δ in Figure 6. Thus if the main energy of the pulse is elsewhere in the symbol period, the divider should be reset appropriately.

A convenient method of achieving this is to use the magnitudes of the complex values formed by accumulating the pulse signal for successive Δ/2 periods. The position of the largest of these values in a symbol period is found and if this is not one of the four positions within -Δ and Δ, then the divider is reset.

The time synchronization system described can consistently choose an optimum position to start the FFT over a wide range of signal conditions.

Many modifications may be made to the system illustrated, which is one example only of an implementation of the present invention. In particular it should be noted that the circuits which have been described as hardware components could be partially or wholly implemented in software. In that case Figure 4 or the appropriate parts thereof should be regarded as being in the nature of a flowchart or diagram.

## Claims

1. A timing synchronization circuit for an OFDM signal receiver, comprising:
an input (12) for receiving an OFDM signal;
a symbol pulse separator (14-20) coupled to the input for separating a symbol pulse from the received OFDM signal;
phase comparison circuitry (72) coupled to the symbol pulse separation for comparing the separated symbol pulses with comparison waveforms;
first and second loop filter circuits (52; 54,56) coupled to the phase comparison circuitry, the first and second loop filter circuits having different filtering characteristics;
a combiner (58) coupled to combine the outputs of the first and second loop filter circuits;
a controlled clock (40) having its control input coupled to the output of the combiner, and
a symbol divider circuit (42) coupled to the output of the clock for providing symbol rate pulses for timing and synchronization control, the symbol divider circuit further generating the comparison waveforms which are applied to the phase comparison circuitry;
**characterized in that**:
the symbol divider circuit (42) generates different first and second comparison waveforms; and
the phase comparison circuitry (72) comprises first and second phase comparators (86,88) each coupled to the symbol pulse separator and to the symbol divider circuit for comparing the separated symbol pulses with the different first and second comparison waveforms respectively, and the first phase comparator providing an output to the first loop filter circuit and the second phase comparator providing an output to the second loop filter circuit.

2. A timing synchronization circuit according to claim 1, in which the second phase comparator (88) responds only outside a defined range of relative input phase position.

3. A timing synchronization circuit according to claim 1 or 2, further comprising a crash-lock circuit (46) for resetting the symbol divider circuit (42) if the relative input phases are outside a defined range.

4. A timing synchronization circuit according to claim 3, in which the crash-lock circuit (46) measures the position of the main energy in the received symbol pulses, and if the main energy is outside a defined range resets the symbol divider circuit.

5. A timing synchronization circuit according to any of claims 1 to 4, further comprising a processor (30) coupled between the symbol pulse separator and the phase comparison circuitry for normalising the magnitude of the symbol pulses.

6. A timing synchronization circuit according to any of claims 1 to 5, in which the first and second phase comparators (86,88) respond only inside a predetermined range of relative input phase positions centred on the desired phase position.

7. An OFDM receiver having a Fast Fourier Transform converter and incorporating a timing synchronization circuit in accordance with any of claims 1 to 6 to supply timing synchronization pulses to the Fast Fourier Transform converter.

8. A method of synchronizing an OFDM signal receiver, comprising the steps of:
receiving an OFDM signal;
separating a symbol pulse from the received OFDM signal;
phase comparing the separated symbol pulses with comparison waveforms;
filtering the resultant of the comparing step with respective first and second loop filtering characteristics;
combining the first and second filtered signals and controlling a clock in dependence thereon;
providing, from the clock, symbol rate pulses for timing and synchronization control, as well as the comparison waveforms which are used in the phase comparison;
**characterized in that**:
different first and second comparison waveforms are generated from the clock; and
the phase comparison comprises first and second phase comparisons for comparing the separated symbol pulses with the different first and second comparison waveforms respectively, and the resultant of the first phase comparison being subjected to the first loop filtering operation and the resultant of the second phase comparator being subjected to the second loop filtering operation.
